# EUROPEAN PATENT APPLICATION

(11) **EP 4 550 576 A1**
(43) Date of publication of application: **07.05.2025**
(21) Application number: 22949363.0
(22) Date of filing: 29.06.2022
(51) Int. Cl.: H01Q 7/06, H05K 3/34

(54) **ANTENNA DEVICE**

(71) Applicant: SUMIDA CORPORATION, Tokyo 104-0042 (JP)
(72) Inventor: IWASAKI, Noriaki, Natori City, Miyagi 9811226 (JP)
(74) Representative: Grünecker Patent- und Rechtsanwälte PartG mbB
(86) International application number: PCT/JP2022/026005
(87) International publication number: WO 2024/004088

(57) **Abstract**

This antenna device includes a base (4b) having a mounting portion (land (16a)), and a chip electronic component (capacitor chip (12)). The land (16a) includes at least a pair of mounting terminals (16c) for mounting the capacitor chip (12). The base (4b) has an uneven portion (20) formed at an edge portion (4g) of an opening (4e). The uneven portion (20) includes a recess (21) and a protrusion (22), and protrudes and is recessed in a direction in which the mounting terminals (16c) that form a pair are aligned at the edge portion (4g) of the opening (4e). The protrusion (22) defines a mounting space at a position where at least a pair of terminals (12a) of the capacitor chip (12) faces the mounting terminals (16c) that form a pair.

## Description

### TECHNICAL FIELD

The present invention relates to an antenna device on which a chip electronic component is mounted.

### BACKGROUND ART

In recent years, a keyless entry system capable of transmitting and receiving radio signals upon locking and unlocking doors provided in a vehicle, a house, or the like has been put into practical use.

In order to implement a keyless entry system, antenna devices capable of transmitting and receiving radio signals, such as low-frequency (LF) transmission antennas, are widely employed.

For example, an antenna device disclosed in Patent Document 1 includes a base with a through opening, a coil, a terminal member, and a capacitor. The terminal member has a chip support piece partially exposed from the opening of the base. The capacitor is mounted on the chip support piece by reflow-soldering.

In order to prevent positional displacement of the capacitor at the time of reflow (to maintain physical and electrical connection with a mounting terminal), the terminal member is provided with a plurality of protrusions.

### CITATION LIST

### PATENT DOCUMENTS

Patent Document 1: JP 2017-103549 A

### SUMMARY OF THE INVENTION

### PROBLEM TO BE SOLVED BY THE INVENTION

However, in order to provide the protrusions on the terminal member in the antenna device disclosed in Patent Document 1, it is necessary to select a material having suitable plasticity and toughness, and the thickness of the material itself is also necessary.

The present invention has been made in view of the above problem, and an object thereof is to provide an antenna device capable of suitably maintaining physical and electrical connection with a mounting terminal.

### MEANS FOR SOLVING THE PROBLEM

The present invention provides an antenna device including: a base having an opening and a mounting portion in the opening; and a chip electronic component mounted on the mounting portion, wherein the mounting portion includes at least a pair of mounting terminals for mounting the chip electronic component, the base has an uneven portion formed at an edge portion of the opening, the uneven portion includes a recess and a protrusion, and protrudes and is recessed at the edge portion of the opening in a direction in which paired mounting terminals included in the at least a pair of mounting terminals are aligned, and the protrusion defines a mounting space for the chip electronic component, the mounting space being defined at a position where at least a pair of terminals of the chip electronic component faces the paired mounting terminals.

### EFFECT OF THE INVENTION

The present invention can provide an antenna device capable of positioning the chip electronic component to satisfactorily maintain physical and electrical connection with a mounting terminal due to the protrusion being provided on the base portion.

### BRIEF DESCRIPTION OF THE DRAWINGS

[Fig. 1] Fig. 1 is a perspective view of an antenna device.
[Fig. 2] Fig. 2 is an enlarged view of a region II in Fig. 1, and is a front view illustrating an opening.
[Fig. 3] Fig. 3 is a front view illustrating the opening in which a capacitor chip in a state of being in contact with a protrusion is provided.
[Fig. 4] Fig. 4 is a schematic cross-sectional view taken along line IV-IV in Fig. 2.
[Fig. 5] Fig. 5 is a front view illustrating the opening in a state where a fillet is formed between a terminal of the capacitor chip and a mounting terminal.
[Fig. 6] Fig. 6 is a front view illustrating an opening in which a protrusion according to a first modification is provided.
[Fig. 7] Fig. 7 is a schematic cross-sectional view, corresponding to Fig. 4, illustrating a protrusion according to a second modification.

### DESCRIPTION OF EMBODIMENTS

An embodiment of the present invention will be described below with reference to the drawings.

Note that the embodiment described below is merely an example for facilitating understanding of the present invention, and does not limit the present invention. That is, the shape, dimensions, arrangement, and the like of the members described below can be changed and modified without departing from the gist of the present invention, and it is a matter of course that the present invention includes equivalents thereof.

In addition, the various components of the present invention do not need to be independent from each other. In the present invention, a plurality of components may be formed as a single component, one component may be divided into a plurality of components, a certain component may be a part of another component, or a part of a certain component may overlap a part of another component, for example.

In all the drawings, the same components are denoted by the same reference numerals, and redundant description will not be repeated. In addition, while the vertical direction may be defined in the description of the present specification, such definition is set for convenience of describing the relative relationship between components, and does not limit the direction of a product according to the present invention when the product is manufactured or used.

### <Overview of Antenna Device>

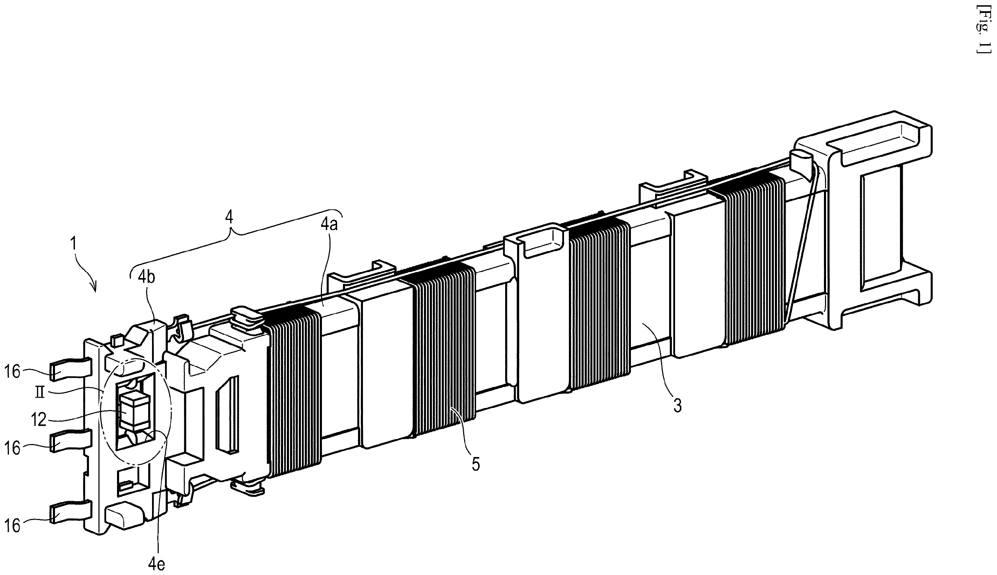

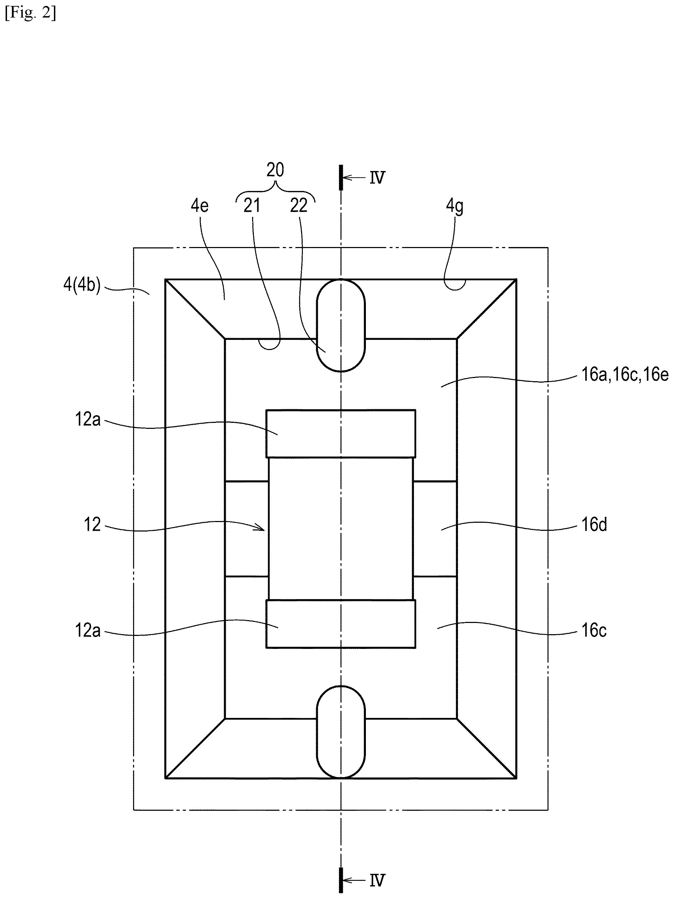

First, an overview of an antenna device 1 will be described mainly with reference to Figs. 1 and 2.

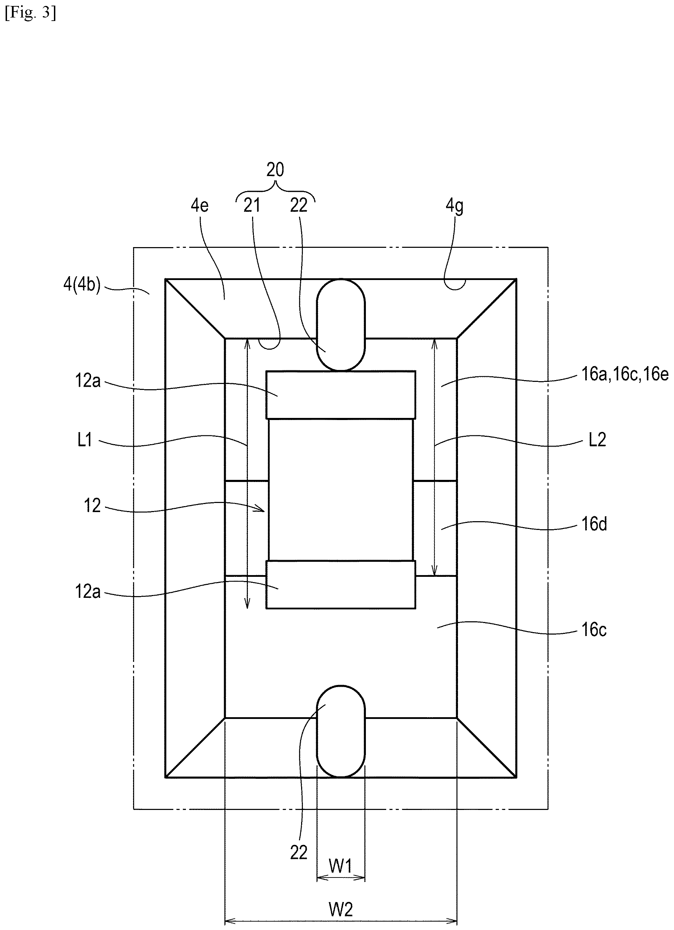

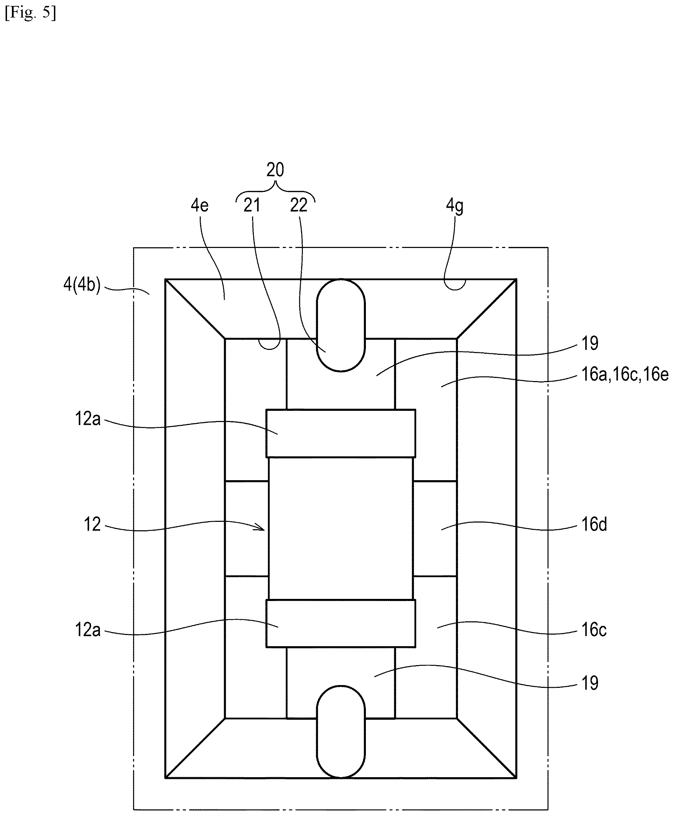

Fig. 1 is a perspective view of the antenna device 1, and Fig. 2 is an enlarged view of a region II in Fig. 1, and is a front view illustrating an opening 4e. Note that Fig. 2 and Fig. 3 to be described later do not illustrate a fillet 19 illustrated in Fig. 5.

The antenna device 1 includes a base 4b having a mounting portion (land 16a) in the opening 4e, and a chip electronic component (capacitor chip 12) mounted on the land 16a. The land 16a includes at least a pair of mounting terminals 16c for mounting the capacitor chip 12.

The base 4b has an uneven portion 20 formed on an edge portion 4g of the opening 4e. The uneven portion 20 includes a recess 21 and a protrusion 22, and protrudes and is recessed in a direction in which the mounting terminals 16c that form a pair are aligned at the edge portion 4g of the opening 4e.

The protrusion 22 defines a mounting space for the capacitor chip 12 at a position where at least a pair of terminals 12a of the capacitor chip 12 faces the paired mounting terminals 16c.

The position where the pair of terminals 12a faces the paired mounting terminals 16c may be any location specifically as long as any part of one of the paired mounting terminals 16c is in contact with any part of one of the pair of terminals 12a of the capacitor chip 12, and any part of the other of the paired mounting terminals 16c is in contact with any part of the other of the pair of terminals 12a of the capacitor chip 12.

Specifically, the uneven portion 20 is provided on each of faces facing each other in the direction in which the paired mounting terminals 16c are aligned in the edge portion 4g of the opening 4e, as illustrated in Fig. 2.

In the present specification, the term "facing" is not limited to the meaning that objects face each other in parallel with each other, and includes the meaning that objects face each other with an inclination at an angle equal to or more than 0° and less than ±90° when the parallel state is defined as 0°.

The recess 21 is recessed farther away from the center of the opening 4e with respect to the protrusion 22 in the direction in which the paired mounting terminals 16c are aligned. On the other hand, the protrusion 22 protrudes toward the center of the opening 4e with respect to the recess 21 in the direction in which the paired mounting terminals 16c are aligned.

Besides the capacitor chip 12 described in the present embodiment, a resistance chip, for example, may be used as the chip electronic component.

According to the above configuration, each of the pair of terminals 12a provided on the chip electronic component (capacitor chip 12) can be suitably disposed at a position facing the corresponding one of the paired mounting terminals 16c by the protrusions 22 provided on the base 4b.

In addition, since the uneven portion 20 is provided in a part of the base 4b instead of the mounting terminal 16c, the material of the mounting terminal 16c can be freely selected from conductive materials, whereby the material can be decreased in thickness to reduce the material cost.

### [Overall configuration]

Next, an overall configuration of the antenna device 1 will be described. As illustrated in Fig. 1, the antenna device 1 mainly includes a long plate-shaped core 3, a base portion 4 that holds the core 3, a coil 5 spirally wound around the base portion 4 at a plurality of locations at intervals, and a capacitor chip 12.

The core 3 amplifies a magnetic field generated from the coil 5, and is accommodated in the base portion 4 (a bobbin 4a to be described later) with a part thereof exposed. The core 3 is formed in an elongated shape and has a flat cross-sectional shape (rectangular shape) in a cross section perpendicular to the longitudinal direction.

Examples of the material of the core 3 include a material made of ceramics containing iron oxide as a main component (ferrite core), a material made of an amorphous alloy (amorphous core), a material obtained by compression molding a metal powder (dust core), and a material having a multilayer structure (multilayer core) including a plurality of electromagnetic steel sheets that is electrically insulated.

The coil 5 is an element that is a main part of an inductance element in a series resonance circuit of the antenna device 1. The coil 5 according to the present embodiment is spirally wound around the base portion 4 (bobbin 4a to be described later) at four places at intervals. The end of the coil 5 is connected to a lead frame 16 illustrated in Fig. 1.

The base portion 4 according to the present embodiment is formed of an insulating material such as resin, and insulates the core 3 accommodated therein from the coil 5 wound around the bobbin 4a as illustrated in Fig. 1.

The base portion 4 includes a bobbin 4a which is located at a central portion in the longitudinal direction and around which the coil 5 is spirally wound, and bases 4b which are formed on both sides of the bobbin 4a, the bobbin 4a and the bases 4b being continuously connected. The base 4b on one side has an opening 4e and is mounted with the capacitor chip 12 in the opening 4e.

### [Opening]

Next, the opening 4e provided in the base portion 4 will be described in detail.

In the antenna device 1 according to the present embodiment, the opening 4e is provided in the base 4b in order to expose the mounting terminals 16c (lands 16a) from the base 4b and mount the capacitor chip 12. The opening 4e does not penetrate the base 4b in the thickness direction. In other words, the opening 4e is formed to be thinner than the periphery of the base 4b, and exposes the land 16a to form a mounting space for the capacitor chip 12.

In the present embodiment, the opening 4e is formed in a double rectangular shape in plan view, and is formed to open in a flare shape towards the opening direction (towards the direction out of page of Fig. 2) in the depth direction.

That is, the edge portion 4g of the opening 4e is formed to be inclined with respect to the opening part and the later-described land 16a located on the opposite side of the opening part.

In plan view, a pair of lands 16a described later is provided on the bottom surface of the opening 4e.

### [Uneven Portion]

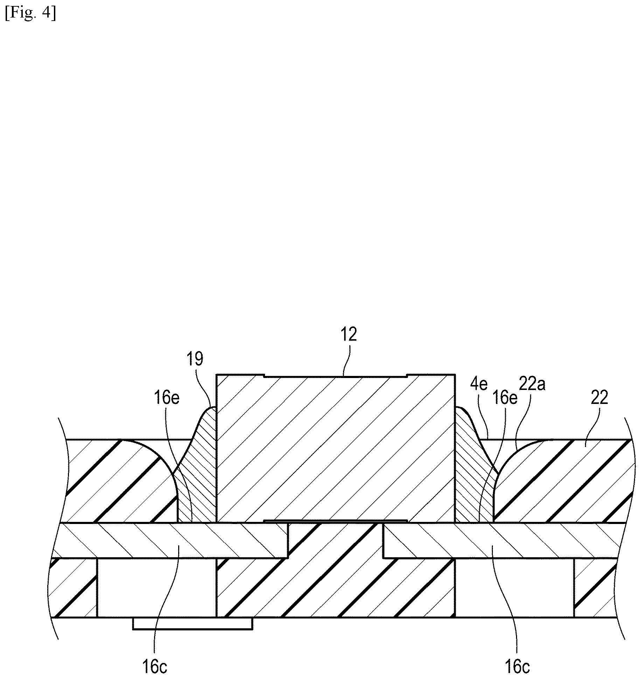

Next, the uneven portion 20 that defines the mounting position of the capacitor chip 12 and ensures a region where the fillet 19 is to be formed will be described mainly with reference to Figs. 3 and 4 in addition to Figs. 1 and 2.

Fig. 3 is a front view illustrating the opening 4e in which the capacitor chip 12 in a state of being in contact with the protrusion 22 is provided. Fig. 4 is a schematic cross-sectional view taken along line IV-IV in Fig. 2.

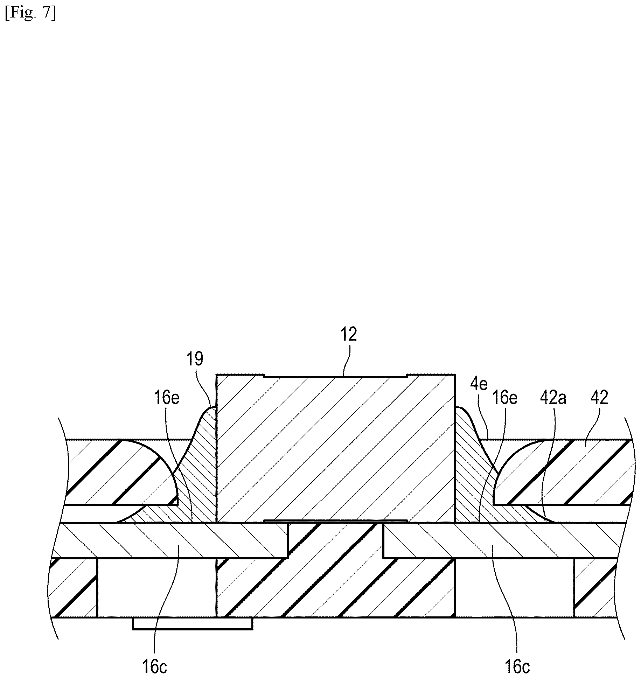

Fig. 4 and Fig. 7 described later illustrate the simplified cross section of the capacitor chip 12, and illustrate the fillet 19 unlike Figs. 2 and 3.

As illustrated in Figs. 2 to 4, the uneven portion 20 is provided on each of faces facing each other in the direction in which the paired mounting terminals 16c are aligned in the edge portion 4g of the opening 4e. Among the recess 21 and the protrusion 22 constituting the uneven portion 20, the protrusion 22 functions as a positioning portion that defines the position of the capacitor chip 12.

Being "uneven" in this specification is relative, and when only a protrusion is formed on a side (precisely, a face) in plan view of the opening 4e, a section other than the protrusion is referred to as a recess. Conversely, when only a recess is formed in this side (precisely, face), a section other than the recess is referred to as a protrusion. That is, there is no case in which either the protrusion or the recess is only formed.

The uneven portion 20 may be provided on one of the faces facing each other in the direction in which the paired mounting terminals 16c are aligned. Even in such a case, the chip electronic component (capacitor chip 12) can be positioned on the side where the uneven portion 20 is provided, and the formation region of the fillet 19 illustrated in Fig. 5 can be ensured.

However, by providing the uneven portion 20 on each of the faces facing each other, that is, on both sides, the capacitor chip 12 can be positioned on both sides in the direction in which the paired mounting terminals 16c are aligned.

With this configuration, the formation region of the fillet 19 can be ensured on both sides of the capacitor chip 12, whereby it is possible to prevent a tombstone state (the capacitor chip 12 is bonded on one side but is separated on the other side) due to a tensile force generated from one side at the time of reflow because of imbalance in the amount of solder. Thus, this configuration is more preferable.

In the present embodiment, the protrusion 22 is disposed at the central part of the mounting surface 16e in the direction (width direction) perpendicular to the direction in which the paired mounting terminals 16c are aligned in plan view of the opening 4e.

The "central part of the mounting surface 16e in the direction perpendicular to the direction in which the paired mounting terminals 16c are aligned" where the protrusion 22 is arranged refers to, for example, a section within a region of 40% on the central side with respect to the entire length of the mounting surface 16e in the perpendicular direction.

According to the above configuration, the protrusion 22 is disposed in the central part of the mounting surface 16e, which allows the fillet 19 to be formed on both sides of the protrusion 22 of the mounting surface 16e. Therefore, the bonding strength between the terminals 12a of the capacitor chip 12 and the mounting terminals 16c can be increased.

In particular, the pair of protrusions 22 is formed at the center of the mounting region in the width direction in Fig. 3, and the width dimension of the capacitor chip 12 is larger than half of the opening 4e. With this configuration, no matter how much the capacitor chip 12 moves in the horizontal direction (width direction), the upper side of the capacitor chip 12 comes in contact with the protrusion 22, so that the capacitor chip 12 is positioned by the protrusion 22.

However, the present invention is not limited to such a configuration, and as described above, it is preferable that the protrusions 22 are provided respectively on the faces facing each other in the direction in which the paired mounting terminals 16c are aligned, and the arrangement and the number thereof can be freely set.

It is to be noted that, by reducing the number of the protrusions 22, a wide formation region of the fillet 19 can be ensured, whereby an occurrence of solder cracks can be prevented.

Since the recess 21 is formed in the edge portion 4g of the opening 4e, the fillet 19 is smoothly and continuously formed so as to spread like a skirt with a reduced thickness toward the edge portion 4g of the opening 4e in the land 16a from the terminal 12a of the capacitor chip 12. Since the fillet 19 is formed in this manner, concentration of stress is reduced, and solder cracks are less likely to occur.

The protrusion 22 is formed to be decreased in width toward a protruding side in plan view of the opening 4e.

In the present embodiment, the protruding end of the protrusion 22 is formed in a semicircular shape in plan view of the opening 4e, so that the protrusion is formed to be decreased in width toward the protruding side.

However, the protrusion 22 is not limited to the shape described above as long as it is formed to be decreased in width toward the protruding side, and may be formed in a staircase pattern.

According to the above configuration, the fillet 19 formed between the terminal 12a of the chip electronic component (capacitor chip 12) and the mounting terminal 16c can be formed wider in the width direction of the protrusion 22 due to the decreased width of the protrusion 22.

Furthermore, the protrusion 22 according to the present embodiment is preferably formed to be gradually decreased in width toward the protruding side in plan view of the opening 4e.

As described above, the protrusion 22 according to the present embodiment is formed in such a manner that a portion protruding from the recess 21 is formed in a semicircular shape in plan view of the opening 4e, and thus, the protrusion 22 is smoothly decreased in width toward the protruding side.

Being "gradually decreased in width" means that the width is decreased smoothly, and is not limited to a configuration in which the face on the protruding side is a curved surface like the semicircular protrusion 22.

The protrusion 22 with a gradually decreased width includes a protrusion inclined in the protruding direction of the protrusion 22 to be decreased in width in plan view of the opening 4e, for example, a protrusion formed in a trapezoidal shape.

According to the above configuration, the protrusion 22 is gradually decreased in width toward the protruding side, whereby the fillet 19 formed between the terminal 12a of the chip electronic component (capacitor chip 12) and the mounting terminal 16c is easily formed continuously along the protrusion 22.

As illustrated in Fig. 4, an upper surface 22a of the protrusion 22 (a surface reverse to the side facing the mounting surface 16e) is inclined so as to approach the mounting surface 16e with nearness to the center side of the opening 4e in a virtual plane perpendicular to the mounting surface 16e of the mounting terminal 16c and including a direction in which the paired mounting terminals 16c are aligned.

The "upper surface" refers to a surface reverse to a surface facing the mounting terminal 16c, and "upper side and lower side" are independent of the direction of gravity.

According to the above configuration, it is possible to prevent the protrusion 22 from interfering with the arrangement of the chip electronic component (capacitor chip 12) on the central side of the opening 4e.

Specifically, the upper surface 22a of the protrusion 22 is inclined downward so as to approach the mounting surface 16e with nearness to the center of opening 4e as described above, whereby the capacitor chip 12 can be guided toward the center of opening 4e.

More specifically, even if the capacitor chip 12 is dropped onto the upper surface 22a of the protrusion 22, the capacitor chip 12 slides on the upper surface 22a of the protrusion 22 by reaction force applied from the protrusion 22 to the center side of the opening 4e or by own weight of the capacitor chip 12, and thus, the capacitor chip 12 can be guided toward the center of the opening 4e where the mounting terminals 16c are exposed.

As illustrated in Fig. 3, a length W1 of the protrusion 22 is shorter than a length W2 of the mounting terminal 16c in a direction perpendicular to the direction in which the paired mounting terminals 16c are aligned in plan view of the opening 4e.

According to the above configuration, a region of the fillet 19 to be formed between the terminal 12a of the chip electronic component (capacitor chip 12) and the mounting terminal 16c can be formed in a section of the mounting terminal 16c not overlapping the protrusion 22.

### [Mounting Portion]

Next, a mounting portion (land 16a, mounting terminal 16c) will be described mainly with reference to Fig. 5 in addition to Figs. 3 and 4. Fig. 5 is a front view illustrating the opening 4e in a state where the fillet 19 is formed between the terminals 12a of the capacitor chip 12 and the mounting terminals 16c.

The lands 16a are a part of the lead frames 16 and are the mounting terminals 16c to which the terminals 12a of the capacitor chip 12 are bonded via solder. Another part of the lead frames 16 is disposed inside the base portion 4, and the pair of lands 16a is exposed to the outside from the base portion 4.

The paired mounting terminals 16c are aligned with a clearance 16d therebetween. As illustrated in Fig. 3, the total length L1 of the protruding length of the protrusion 22 from the recess 21 into the mounting space and the longitudinal dimension of the chip electronic component (capacitor chip 12) is longer than the shortest length L2 from the recess 21 to the mounting terminal 16c located on the distal side with respect to the clearance 16d in the paired mounting terminals 16c.

The "longitudinal dimension of the chip electronic component" as used herein is a dimension from an end of the chip electronic component (capacitor chip 12) coming in contact with the protrusion 22 to a distal end (lower end in Fig. 3) of the terminal 12a located on the distal side.

The relationship between the length L1 and the length L2 is established not only for the relationship between the upper protrusion 22 and the lower mounting terminal 16c illustrated in Fig. 3 but also for the relationship between the lower protrusion 22 and the upper mounting terminal 16c.

In the above description, the mounting terminal 16c located on the "distal side" for defining the length L2 refers to the mounting terminal 16c located away from the recess 21 used as a reference for defining the length L1.

According to the above configuration, the chip electronic component (capacitor chip 12), the uneven portion 20 (the recess 21 and the protrusion 22), and the mounting terminal 16c have the above relationship in terms of length, whereby the pair of terminals 12a of the capacitor chip 12 positioned by the protrusion 22 is always positioned on the mounting terminals 16c.

The mounting terminals 16c are preferably metal terminals that are insert molded into the base 4b.

According to the above configuration, the mounting terminals 16c are formed by insert molding at the time of injection molding of the base portion 4, whereby the mounting terminals 16c can be easily disposed in the opening 4e.

The mounting terminals 16c may be a thin-film conductive material formed on the base 4b by printing.

According to the above configuration, the protrusion 22 is formed on the base 4b, so that it is not necessary to increase the thickness of a part of the mounting terminals 16c for positioning, and the mounting terminals 16c can be formed in a thin film shape by printing. For example, the mounting terminals 16c may be formed in a thin film shape by forming a land pattern including the mounting terminals 16c with a conductive paste or by performing resin plating on the base 4b, and a manufacturing method thereof is not limited.

### (First Modification)

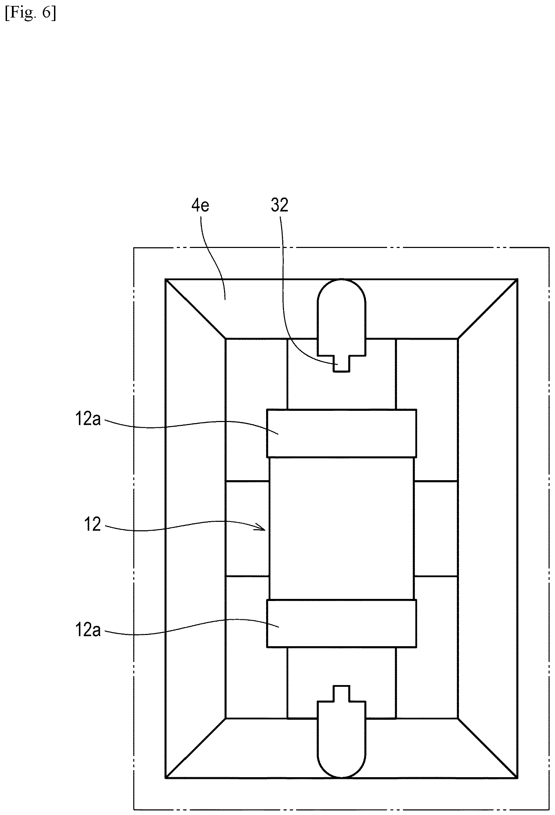

Next, a protrusion 32 according to a first modification will be described with reference to Fig. 6. Fig. 6 is a front view illustrating an opening 4e in which the protrusion 32 according to the first modification is provided.

The protrusion 32 in the present modification has, on its protruding end, a rectangular protruding portion that is smaller in width than a proximal portion in plan view of the opening 4e. Thus, the protrusion 32 is decreased in width toward the protruding side. That is, the protrusion 32 is formed to be decreased stepwise in width toward the protruding side in plan view of the opening 4e.

According to the above configuration, the fillet 19 formed between the terminal 12a of the chip electronic component (capacitor chip 12) and the mounting terminal 16c can be formed wider in the width direction of the protrusion 32 due to the decreased width of the protrusion 32.

Note that the protrusion 32 may have a plurality of steps.

### (Second Modification)

Next, a protrusion 42 according to a second modification will be described with reference to Fig. 7. Fig. 7 is a schematic cross-sectional view, corresponding to Fig. 4, illustrating the protrusion 42 according to the second modification.

As illustrated in Fig. 7, the protrusion 42 according to the present modification is located away from the mounting terminal 16c in the mounting direction (direction perpendicular to the mounting surface 16e).

Specifically, a clearance 42a is formed between the protrusion 42 and the mounting terminal 16c. Solder enters the clearance 42a to form a fillet 19, and the protrusion 42 and the mounting terminal 16c are joined and integrated via the fillet 19 in the clearance 42a.

As described above, since the protrusion 42 is separated from the mounting terminal 16c (protrudes like eaves), it is possible to prevent the protrusion 42 separated from the mounting terminal 16c from interfering with the formation of the fillet 19.

In particular, since the fillet 19 is likely to gather on the mounting terminal 16c side by its own weight, the formation of the clearance 42a between the protrusion 42 and the mounting terminal 16c can effectively prevent the interference with the formation of the fillet 19.

If it is difficult to mold the protrusion 42 when the base 4b is injection-molded, the protrusion 42 may be provided later on another portion of the base 4b.

The above embodiment and modifications include the following technical ideas.
(1) An antenna device including:
   a base having an opening and a mounting portion in the opening; and
   a chip electronic component mounted on the mounting portion, wherein
   the mounting portion includes at least a pair of mounting terminals for mounting the chip electronic component,
   the base has an uneven portion formed at an edge portion of the opening,
   the uneven portion includes a recess and a protrusion, and protrudes and is recessed at the edge portion of the opening in a direction in which paired mounting terminals included in the at least a pair of mounting terminals are aligned, and
   the protrusion defines a mounting space for the chip electronic component, the mounting space being defined at a position where at least a pair of terminals of the chip electronic component faces the paired mounting terminals.
(2) The antenna device according to (1), wherein
   the paired mounting terminals are aligned with a clearance being formed between the paired mounting terminals, and
   a total length of a protruding length of the protrusion from the recess into the mounting space and a longitudinal dimension of the chip electronic component is longer than a shortest length from the recess to the mounting terminal located on a distal side with respect to the clearance in the paired mounting terminals.
(3) The antenna device according to claim (1) or (2), wherein the uneven portion is provided on each of faces facing each other in the direction in which the paired mounting terminals are aligned in the edge portion of the opening.
(4) The antenna device according to any one of (1) to (3), wherein the protrusion is formed to have a width decreased toward a protruding side in plan view of the opening.
(5) The antenna device according to (4), wherein the protrusion is formed to have a width gradually decreased toward the protruding side in plan view of the opening.
(6) The antenna device according to any one of (1) to (5), wherein, in a virtual plane perpendicular to mounting surfaces of the mounting terminals and including the direction in which the paired mounting terminals are aligned, an upper surface of the protrusion is inclined downward so as to approach the mounting surfaces with nearness to a center of the opening.
(7) The antenna device according to any one of (1) to (6), wherein the protrusion is located away from the mounting terminal in a mounting direction.
(8) The antenna device according to any one of (1) to (7), wherein a length of the protrusion is shorter than a length of each of the mounting terminals in a direction perpendicular to the direction in which the paired mounting terminals are aligned in plan view of the opening.
(9) The antenna device according to (8), wherein the protrusion is disposed at a central part of a mounting surface in the direction perpendicular to the direction in which the paired mounting terminals are aligned in plan view of the opening.
(10) The antenna device according to any one of (1) to (9), wherein each of the mounting terminals is a metal terminal that is insert molded on the base.
(11) The antenna device according to any one of (1) to (10), wherein each of the mounting terminals is a conductive material formed into a thin film shape on the base by printing.

### REFERENCE SIGNS LIST

- 1: antenna device
- 3: core
- 4: base portion
- 4a: bobbin
- 4b: base
- 4e: opening
- 4g: edge portion
- 5: coil
- 12: capacitor chip (chip electronic component)
- 12a: terminal
- 16: lead frame
- 16a: land (mounting portion)
- 16c: mounting terminal
- 16d: clearance
- 16e: mounting surface
- 19: fillet
- 20: uneven portion
- 21: recess
- 22, 32, 42: protrusion
- 22a: upper surface
- 42a: clearance

## Claims

1. An antenna device comprising:
a base having an opening and a mounting portion in the opening; and
a chip electronic component mounted on the mounting portion, wherein
the mounting portion includes at least a pair of mounting terminals for mounting the chip electronic component,
the base has an uneven portion formed at an edge portion of the opening,
the uneven portion includes a recess and a protrusion, and protrudes and is recessed at the edge portion of the opening in a direction in which paired mounting terminals included in the at least a pair of mounting terminals are aligned, and
the protrusion defines a mounting space for the chip electronic component, the mounting space being defined at a position where at least a pair of terminals of the chip electronic component faces the paired mounting terminals.

2. The antenna device according to claim 1, wherein
the paired mounting terminals are aligned with a clearance being formed between the paired mounting terminals, and
a total length of a protruding length of the protrusion from the recess into the mounting space and a longitudinal dimension of the chip electronic component is longer than a shortest length from the recess to the mounting terminal located on a distal side with respect to the clearance in the paired mounting terminals.

3. The antenna device according to claim 1 or 2, wherein the uneven portion is provided on each of faces facing each other in the direction in which the paired mounting terminals are aligned in the edge portion of the opening.

4. The antenna device according to any one of claims 1 to 3, wherein the protrusion is formed to have a width decreased toward a protruding side in plan view of the opening.

5. The antenna device according to claim 4, wherein the protrusion is formed to have a width gradually decreased toward the protruding side in plan view of the opening.

6. The antenna device according to any one of claims 1 to 5, wherein, in a virtual plane perpendicular to mounting surfaces of the mounting terminals and including the direction in which the paired mounting terminals are aligned, an upper surface of the protrusion is inclined downward so as to approach the mounting surfaces with nearness to a center of the opening.

7. The antenna device according to any one of claims 1 to 6, wherein the protrusion is located away from the mounting terminal in a mounting direction.

8. The antenna device according to any one of claims 1 to 7, wherein a length of the protrusion is shorter than a length of each of the mounting terminals in a direction perpendicular to the direction in which the paired mounting terminals are aligned in plan view of the opening.

9. The antenna device according to claim 8, wherein the protrusion is disposed at a central part of a mounting surface in the direction perpendicular to the direction in which the paired mounting terminals are aligned in plan view of the opening.

10. The antenna device according to any one of claims 1 to 9, wherein each of the mounting terminals is a metal terminal that is insert molded on the base.

11. The antenna device according to any one of claims 1 to 10, wherein each of the mounting terminals is a conductive material formed into a thin film shape on the base by printing.
